# EUROPEAN PATENT APPLICATION

(11) **EP 4 560 686 A1**
(43) Date of publication of application: **28.05.2025**
(21) Application number: 23842691.0
(22) Date of filing: 31.05.2023
(51) Int. Cl.: H01L 21/56, B29C 45/02, B29C 45/17, H01L 21/677

(54) **CONVEYING DEVICE, RESIN MOLDING DEVICE, AND METHOD FOR MANUFACTURING RESIN MOLDED ARTICLE**

(30) Priority: 22.07.2022 JP 2022116957
(71) Applicant: Towa Corporation, Kyoto-shi, Kyoto 601-8105 (JP)
(72) Inventor: YOSHIDA, Shuhei, Kyoto-shi, Kyoto 601-8105 (JP)
(74) Representative: Müller Hoffmann & Partner
(86) International application number: PCT/JP2023/020368
(87) International publication number: WO 2024/018759

(57) **Abstract**

The present invention enables positioning of an object to be molded with respect to a pot block having an overhang, and is a conveying apparatus 13 that conveys an object to be molded W1 to a lower mold 15 provided with a pot block 141 having an overhang 141b, including a substrate holder 3 that holds the object to be molded W1, and a holder moving mechanism 4 that moves the substrate holder 3, wherein the holder moving mechanism 4 moves the substrate holder 3 toward the pot block 141 in a state where the object to be molded W1 is separated from the lower mold 15 to bring the object to be molded W1 into contact with a lower side 141c of the overhang 141b of the pot block 141, and the substrate holder 3 releases holding of the object to be molded W1 after the object to be molded W1 is brought into contact with the side 141c by the holder moving mechanism 4.

## Description

### Technical Field

The present invention relates to a conveying apparatus, a resin molding apparatus, and a resin molded product manufacturing method.

### Background Art

As a conveying apparatus that conveys a object to be molded to a lower mold provided with a cal block having an overhang, a conveying apparatus disclosed in Patent Literature 1 has conventionally been considered.

Specifically, the conveying apparatus is configured to place the object to be molded on the upper surface of the lower mold, then move the object to be molded toward the cal block with a first contact part (approach pin) of a first moving mechanism, and bring the pot-side end face of the object to be molded into contact with an end face of the cal block for positioning.

### Citation List

### Patent Literature

Patent Literature 1: JP 6655148 B

### Summary of Invention

### Technical Problem

However, for example, when a pilot pin for positioning is provided in the lower mold, the object to be molded interferes with the pilot pin, and the pot-side end surface of the object to be molded cannot be brought into contact with the end surface of the cal block in some cases. **In** addition, for example, when a release film is provided on the lower mold, the first contact part (approach pin) may come into contact with the release film to cause molding defects. Here, it is conceivable to form a relief groove or the like also in the release film, but the cost increases. Further, for example, in a case where an electronic component is fixed to the lower surface of the object to be molded, the electronic component fixed to the lower surface of the object to be molded may be damaged or a similar situation may happen when the object to be molded is moved in a state of being placed on the lower mold.

The present invention has been made to solve the above problems, and it is a main object of the present invention to enable positioning of an object to be molded with respect to a lower mold by using a conveying apparatus even when, for example, a pilot pin or a release film is provided in the lower mold or an electronic component is fixed to a lower surface of the object to be molded.

### Solution to Problem

A conveying apparatus according to the present invention is a conveying apparatus that conveys an object to be molded to a lower mold provided with a pot block having an overhang, the conveying apparatus including a substrate holder that holds the object to be molded, and a holder moving mechanism that moves the substrate holder, wherein the holder moving mechanism moves the substrate holder toward the pot block in a state where the object to be molded is separated from the lower mold to bring the object to be molded into contact with a lower side of the overhang of the pot block, and the substrate holder releases holding of the object to be molded after the object to be molded is brought into contact with the side by the holder moving mechanism.

### Advantageous Effects of Invention

According to the present invention configured as described above, the object to be molded can be positioned with respect to the lower mold by the conveying apparatus even when a pilot pin or a release film is provided in the lower mold or when an electronic component is fixed to a lower surface of the object to be molded, for example.

### Brief Description of Drawings

FIG. 1 is a schematic view illustrating a configuration of a resin molding apparatus according to an embodiment of the present invention.
FIG. 2 includes schematic views illustrating a state before clamping (a), a state during clamping (b), and a state after mold opening (c) in a molding module of the embodiment.
FIG. 3 is a front view schematically illustrating a state where a conveying apparatus of the embodiment holds an object to be molded.
FIG. 4 is a side view schematically illustrating a state (second height position) where the conveying apparatus of the embodiment holds the object to be molded.
FIG. 5 is a side view schematically illustrating a configuration of a pot block of the embodiment.
FIG. 6 includes plan views schematically illustrating a state of a holder moving mechanism of the embodiment before the object to be molded is brought into contact with the side of the pot (a), and a state of the holder moving mechanism of the embodiment after the object to be molded is brought into contact with the side of the pot (b).
FIG. 7 is a side view schematically illustrating a state (first height position) where the conveying apparatus of the embodiment holds the object to be molded at a transfer height position.
FIG. 8 is a side view schematically illustrating a state where the conveying apparatus of the embodiment has brought the object to be molded into contact with the side of the pot.
FIG. 9 is a side view schematically illustrating a state where the conveying apparatus of the embodiment has released the holding of the object to be molded and the object to be molded is being guided.
FIG. 10 is a side view schematically illustrating a state where the conveying apparatus of the embodiment has released the holding of the object to be molded and the object to be molded has been placed on a lower mold.
FIG. 11 is a side view schematically illustrating a state where a pressing member of the conveying apparatus of the embodiment is pressing the object to be molded.
FIG. 12 is a side view schematically illustrating a state where the conveying apparatus of the embodiment is leaving from the lower mold after carrying the object to be molded.
FIG. 13 is a side view schematically illustrating a state before the conveying apparatus of the embodiment holds the object to be molded.
FIG. 14 includes partially enlarged views schematically illustrating a stopper mechanism in a state where the pressing member of the embodiment is at the first height position (b), and a state where the pressing member of the embodiment is at a pressing position. Description of Embodiments

Next, the technology according to the present invention will be described in more detail with reference to examples. However, the present invention is not limited by the following technology.

A conveying apparatus of technology 1 according to the present invention is a conveying apparatus that conveys an object to be molded to a lower mold provided with a pot block having an overhang, the conveying apparatus including a substrate holder that holds the object to be molded, and a holder moving mechanism that moves the substrate holder, wherein the holder moving mechanism moves the substrate holder toward the pot block in a state where the object to be molded is separated from the lower mold to bring the object to be molded into contact with a lower side of the overhang of the pot block, and the substrate holder releases holding of the object to be molded after the object to be molded is brought into contact with the side by the holder moving mechanism.

According to this conveying apparatus, the object to be molded is brought into contact with the lower side of the overhang of the pot block in a state where the object to be molded is separated from the lower mold, and thereafter, the holding of the object to be molded is released. Thus, the object to be molded can be positioned with respect to the lower mold and carried in even when a pilot pin or a release film is provided in the lower mold or when an electronic component is fixed to the lower surface of the object to be molded, for example. Since the object to be molded positioned by the conveying apparatus can be sealed in resin, the occurrence of resin burrs can be reduced, and a resin molded product with high quality can be manufactured.

In a conveying apparatus of technology 2 according to the present invention, in addition to the configuration of the technology 1, the holder moving mechanism horizontally moves the substrate holder toward the pot block to bring the object to be molded into contact with the side in a state where the object to be molded is at a height position between an upper surface of the lower mold and the overhang.

This configuration causes the object to be molded to move horizontally, and thus the lower side of the overhang of the pot block and the pot-side end surface of the object to be molded can be reliably brought into contact with each other.

As a specific embodiment of the substrate holder, the following is conceivable.

That is, in a conveying apparatus of technology 3 according to the present invention, in addition to the configuration of the technology 1 or 2, the substrate holder includes a holding claw that holds the object to be molded, and a holding claw drive mechanism that releases holding by the holding claw.

A conveying apparatus of technology 4 according to the present invention further includes, in addition to the technology 3, a base member in which the holding claw is provided to be at least movable up and down, characterized in that the holding claw receives the object to be molded from an outside at a position where the holding claw has lifted with respect to the base member, and releases holding of the object to be molded at a position where the holding claw has lowered with respect to the base member.

**In** the conveying apparatus of the technology 4 according to the present invention, to cause the holding claw to receive the object to be molded from an outside at a position where the holding claw has lifted with respect to the base member and to release holding of the object to be molded at a position where the holding claw has lowered with respect to the base member, the holding claw drive mechanism includes a holding claw drive unit provided in the base member, a first transmission unit that transmits a drive force from the holding claw drive unit to the holding claw at a position where the holding claw has lifted with respect to the base member, and a second transmission unit that transmits the drive force from the holding claw drive unit to the holding claw at a position where the holding claw has lowered with respect to the base member.

**In** the present invention, since the substrate holder holding the object to be molded is moved toward the pot block, the holding claw of the substrate holder may interfere with the pot block.

Thus, in the conveying apparatus of technology 5 according to the present invention, in addition to the configuration of the technology 3 or 4, the pot block is formed with a recess that avoids interference with the holding claw.

In a conveying apparatus of technology 6 according to the present invention, in addition to the configuration of any one of the technologies 1 to 5, the substrate holder includes a guide member that guides the object to be molded released from holding to an upper surface of the lower mold.

With this configuration, the object to be molded is guided by the guide member when the object to be molded released from holding falls onto the upper surface of the lower mold, and thus a state where the pot-side end surface of the object to be molded is in contact with the side of the pot block can be maintained. As a result, the object to be molded is placed on the lower mold in a positioned state.

In a conveying apparatus of technology 7 according to the present invention, in addition to the configuration of any one of the technologies 1 to 6, the substrate holder includes a pressing member that presses the object to be molded placed on the lower mold, and a lifting movement mechanism that moves the pressing member up and down with respect to the object to be molded.

With this configuration, the warpage of the object to be molded can be suppressed by pressing the object to be molded placed on the lower mold with the pressing member.

In a conveying apparatus of technology 8 according to the present invention, in addition to the configuration of the technology 1 or 2, the substrate holder includes a pressing member that presses the object to be molded placed on the lower mold, a lifting movement mechanism that moves the pressing member up and down with respect to the object to be molded, a holding claw that hooks and holds the object to be molded, the holding claw being provided movably in an up-down direction on the pressing member, and a stopper mechanism that keeps the holding claw at a predetermined height position where the holding claw does not come into contact with the lower mold when the pressing member lowers.

With this configuration, since the holding claw is provided in the pressing member, it is possible to reduce the size as compared with a configuration in which the pressing member and the holding claw are separately provided. In such a configuration in which the holding claw is provided on the pressing member, when the pressing member is lowered to press the object to be molded placed on the lower mold, the holding claw provided movably in the up-down direction on the pressing member is held at predetermined height positions by the stopper mechanism. Thus, the holding claw can be prevented from coming into contact with the lower mold or the release film provided on the lower mold.

In a conveying apparatus of technology 9 according to the present invention, in addition to the configuration of the technology 8, the substrate holder further includes a guide member that guides the object to be molded released from holding to an upper surface of the lower mold, the guide member being provided movably in an up-down direction on the pressing member, and the stopper mechanism keeps the guide member at a predetermined height position where the guide member does not come into contact with the lower mold when the pressing member lowers.

With this configuration, since the guide member is provided in the pressing member, it is possible to reduce the size as compared with a configuration in which the pressing member and the guide member are separately provided. In such a configuration in which the guide member is provided on the pressing member, when the pressing member is lowered to press the object to be molded placed on the lower mold, the guide member provided movably in the up-down direction on the pressing member is held at predetermined height positions by the stopper mechanism. Thus, the guide member can be prevented from coming into contact with the lower mold or the release film provided on the lower mold.

In a conveying apparatus of technology 10 according to the present invention, in addition to the configuration of the technology 9, the guide member is movably provided between a guide position where the guide member guides the object to be molded to the upper surface of the lower mold and a retraction position where the guide member is retracted from the guide position, receives elastic force of an elastic member to be positioned at the guide position, and is configured to be movable to the retraction position with movement of the pressing member.

With this configuration, the guide member does not interfere when the object to be molded is delivered to the holding claw or when the pressing member presses the object to be molded.

A resin molding apparatus including the conveying apparatus according to any one of the technologies 1 to 10 is also an aspect of the present invention.

A conveying method for an object to be molded using the conveying apparatus according to any one of the technologies 1 to 10, the conveying method including moving the object to be molded toward the pot block in a state where the object to be molded is separated from the lower mold to bring the object to be molded into contact with the lower side of the overhang of the pot block, and releasing holding of the object to be molded after the object to be molded is brought into contact with the side is also an aspect of the present invention.

A resin molded product manufacturing method for performing resin molding on an object to be molded, the resin molded product manufacturing method including a positioning step of positioning the object to be molded with respect to the pot block by using the conveying apparatus according to any one of the technologies 1 to 10, and a molding step of performing resin molding in a state where the object to be molded is positioned is also an aspect of the present invention.

### <Embodiment of the present invention>

Hereinafter, an embodiment of a resin molding apparatus according to the present invention will be described with reference to the drawings. All the drawings described below are schematically illustrated with appropriate omission or exaggeration for easy understanding. The same components are denoted by the same reference numerals, and the description thereof will be omitted as appropriate.

### <Overall configuration of resin molding apparatus>

A resin molding apparatus 100 of the present embodiment performs resin molding of an object to be molded W1 to which an electronic component Wx is fixed through transfer molding using a resin material J. The object to be molded W1 has a rectangular shape in plan view.

Here, the object to be molded W1 is, for example, a metal substrate, a resin substrate, a glass substrate, a ceramic substrate, a circuit substrate, a semiconductor substrate, a lead frame, a silicon wafer, a glass wafer, or the like, and the presence or absence of wiring is irrelevant. The resin material J for resin molding is, for example, a composite material containing a thermosetting resin, and the form of the resin material J is granular, powder, liquid, sheet, tablet, or the like. Examples of the electronic component Wx include an electronic element such as a semiconductor chip, a resistance element, or a capacitor element, and an electronic component in which at least one of these electronic elements is resin-sealed.

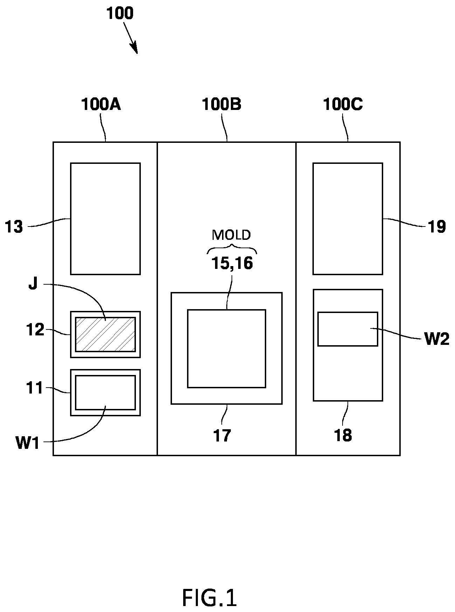

Specifically, as illustrated in FIG. 1, the resin molding apparatus 100 includes, as components, a supply module 100A that supplies the object to be molded W1 before molding and the resin material J, a molding module 100B that performs resin molding, and a storage module 100C that houses an object to be molded W2 after molding (hereinafter, resin molded product W2). The supply module 100A, the molding module 100B, and the storage module 100C can be attached to and detached from each other with respect to other components, and can be replaced with each other.

The supply module 100A includes an object to be molded supply unit 11 that supplies the object to be molded W1, a resin material supply unit 12 that supplies the resin material J, and a conveying apparatus 13 (hereinafter, loader 13) that receives the object to be molded W1 from the object to be molded supply unit 11, conveys the object to be molded W1 to the molding module 100B, receives the resin material J from the resin material supply unit 12, and conveys the object to be molded W1 to the molding module 100B.

The loader 13 moves between the supply module 100A and the molding module 100B, and it moves along a rail (not illustrated) provided across the supply module 100A and the molding module 100B. Details of the loader 13 will be described later.

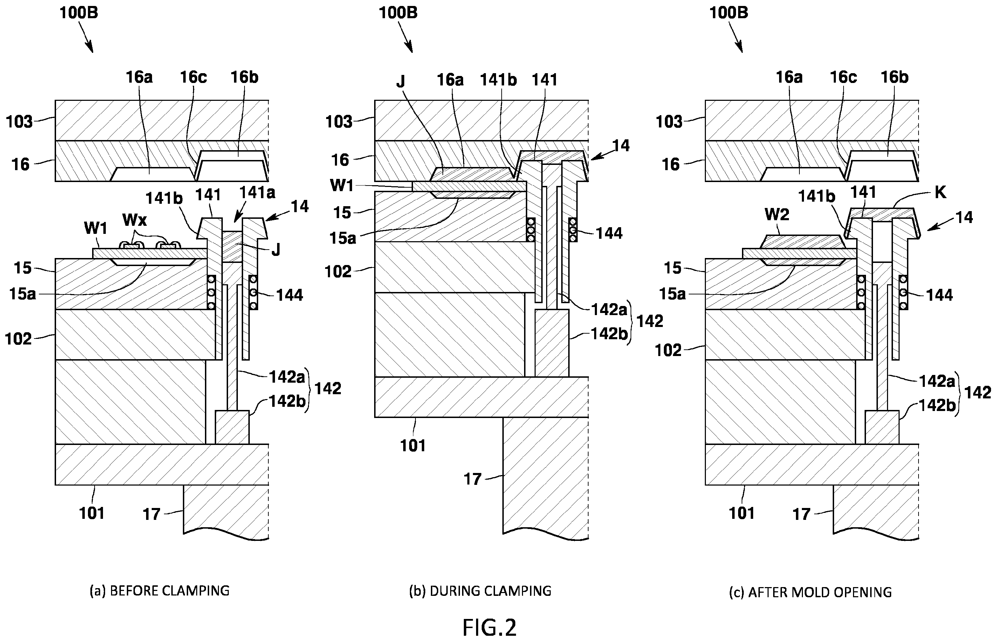

As illustrated in FIG. 2, the molding module 100B includes a lower mold 15 provided with a resin injection unit 14 and formed with a cavity 15a into which the resin material J is injected, an upper mold 16 provided to face the lower mold 15 and formed with a cavity 16a into which the resin material J is injected, and a clamping mechanism 17 that clamps the lower mold 15 and the upper mold 16. The lower mold 15 is provided on a movable platen 101 via a lower platen 102. The movable platen 101 is moved up and down by the clamping mechanism 17. The upper mold 16 is provided on an upper fixed platen (not illustrated) via an upper platen 103. FIG. 2 illustrates only one side (left side) of the resin injection unit 14, and the other side (right side) is omitted. The configuration of the other side in FIG. 2 is the same as the configuration of the one side.

The resin injection unit 14 of the present embodiment includes a pot block 141 in which a pot 141a that houses the resin material J is formed, and a transfer mechanism 142 having a plunger 142a provided in the pot 141a. Here, the transfer mechanism 142 includes the plunger 142a for pressure-feeding the resin material J housed in the pot 141a, and a plunger drive unit 142b that drives the plunger 142a. The plunger 142a pressure-feeds the resin material J heated and melted in the pot 141a.

The pot block 141 is provided in the lower mold 15, and is elastically supported by an elastic member 144 so as to be movable up and down with respect to the lower mold 15. At the upper end of the pot block 141, an overhang 141b overhanging on a mold surface which is the upper surface of the lower mold 15 is formed. In a state where the upper mold 16 and the lower mold 15 are clamped, the upper surface of the overhang 141b comes into contact with the upper mold 16, and the lower surface of the overhang 141b sandwiches the object to be molded W1 with the the mold surface of the lower mold 15 (see FIG. 2(b)). The overhang 141b is a portion protruding above the resin molded product W2 in a state where the upper mold 16 and the lower mold 15 are open after resin molding (see FIG. 2 (c)). Further, on the upper surface of the pot block 141, a cal part and a gate part (both not illustrated) serving as a resin flow path for introducing the resin material J injected from the pot 141a into the cavities 15a and 16a may be formed.

The cavity 15a of the lower mold 15 is for resin-sealing the lower surface of the object to be molded W1, and the cavity 16a of the upper mold 16 is for resin-sealing the upper surface of the object to be molded W1. Here, the electronic component Wx of the object to be molded W1 is housed in at least one of the cavity 15a of the lower mold 15 and the cavity 16a of the upper mold 16.

In the upper mold 16, a recess 16b is formed in a portion facing the overhang 141b of the pot block 141, and a runner 16c that connects the cal part and the gate part to the cavities 15a and 16a is formed. In the lower mold 15, a runner part that connects the cal part and the gate part to the cavities 15a and 16a may be formed. Although not illustrated, the lower mold 15 or the upper mold 16 is formed with an air vent on the opposite side from the pot block 141. The cal part, the runner part, and the gate part form a resin flow path, and the molten resin material J is supplied from the pot to the cavity.

As illustrated in FIG. 2(b), when the lower mold 15 and the upper mold 16 are clamped by the clamping mechanism 17, the pot block 141 lowers, and the pot-side end of the object to be molded W1 is sandwiched between the lower surface of the overhang 141b of the pot block 141 and the upper surface of the lower mold 15. When the resin material J melted by the plunger 142a is injected into the cavities 15a and 16a in this state, the electronic component Wx of the object to be molded W1 is resin-sealed.

The storage module 100C is provided with a storage part 18 that stores the resin molded product W2, and a conveying apparatus 19 (hereinafter, unloader 19) that receives the resin molded product W2 from the molding module 100B and conveys the resin molded product W2 to the storage part 18.

The unloader 19 moves between the molding module 100B and the storage module 100C, and it moves along a rail (not illustrated) provided across the molding module 100B and the storage module 100C.

A basic operation of the resin molding apparatus 100 will be briefly described with reference to FIG. 2. The following operation is performed, for example, by a control unit (not illustrated) provided in the supply module 100A controlling each unit.

In a state where the lower mold 15 and the upper mold 16 are open, the object to be molded W1 is conveyed by the loader 13 and placed on the lower mold 15 as illustrated in FIG. 2(a). At this time, the upper mold 16 and the lower mold 15 are heated to a temperature at which the resin material J can be melted and cured. The resin material J is conveyed by the loader 13 and housed in the pot 141a of the pot block 141.

When the lower mold 15 is lifted by the clamping mechanism 17 in this state, as illustrated in FIG. 2(b), the pot block 141 comes into contact with the upper mold 16 and lowers with respect to the lower mold 15, and the lower surface of the overhang 141b comes into contact with the pot-side end of the object to be molded W1. A lower surface of the upper mold 16 comes into contact with the object to be molded W1 except for the cavity 16a and an air vent portion. This causes the lower mold 15 and the upper mold 16 to be clamped. When the plunger drive unit 142b lifts the plunger 142a after the clamping, the molten resin material J in the pot 141a is injected into the cavities 15a and 16a through the resin flow path. Then, after the resin material J is cured in the cavities 15a and 16a, the molds are opened by the clamping mechanism 17 as illustrated in FIG. 2(c). This mold opening causes the pot block 141 to lift with respect to the lower mold 15, and an unnecessary resin K on the pot block 141 is separated from the resin molded product W2 (gate break). Thereafter, the resin molded product W2 is unloaded by the unloader 19 and conveyed to the storage part 18.

### <Specific configuration of loader 13>

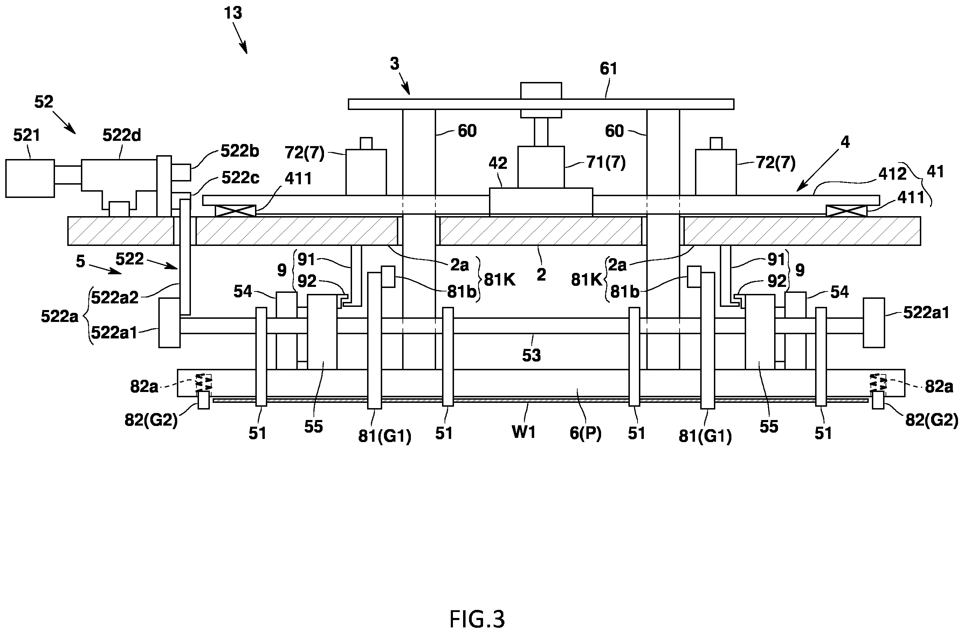

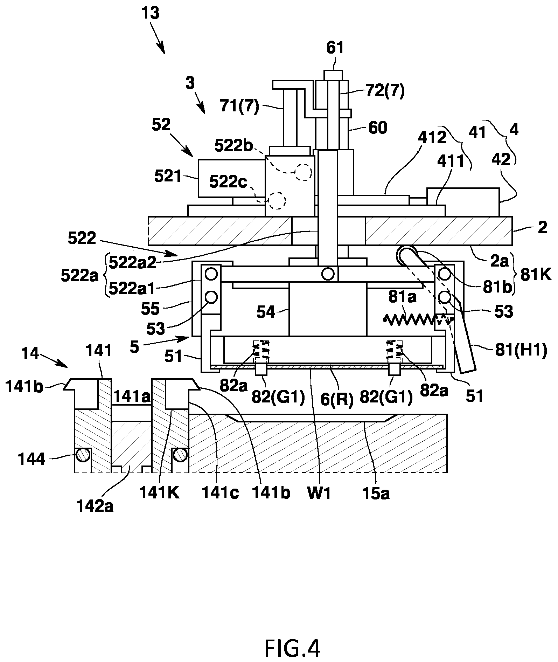

Next, a specific configuration of the loader 13 in the present embodiment will be described with reference to FIGS. 3 to 14. In FIGS. 3, 4, and 7 to 14, illustration of the electronic component Wx is omitted. FIGS. 4 and 6 to 12 illustrate only the other side (right side) of the resin injection unit 14, and one side (left side) is omitted. The configuration of the one side in FIGS. 4 and 6 to 12 is the same as the configuration of the other side. In FIGS. 4 and 7 to 12, illustration of the upper mold 16 is omitted.

As illustrated in FIGS. 3, 4, and 7 to 13, the loader 13 includes a base member 2 provided movably along a rail (not illustrated), a substrate holder 3 provided in the base member 2 to hold the object to be molded W1, and a holder moving mechanism 4 that moves the substrate holder 3 toward the pot block 141 with respect to the base member 2. The base member 2 is provided with a resin holder (not illustrated) that holds the resin material J.

As illustrated in FIGS. 3, 4, and 6 to 13, the substrate holder 3 includes a holding mechanism 5 that holds the object to be molded W1, a pressing member 6 that presses the object to be molded W1 placed on the lower mold 15, and a lifting movement mechanism 7 that moves the pressing member 6 up and down.

As illustrated in FIGS. 3, 4, and 6 to 13, the holding mechanism 5 includes a pair of holding claws 51 that hook and hold both ends of the object to be molded W1, and a holding claw drive mechanism 52 that increases or reduces the interval between the holding claws 51. The holding claw drive mechanism 52 reduces the interval between the holding claws 51 to support and hold at least a part of the lower surface of the object to be molded W1, and increases the interval between the holding claws 51 to release the holding of the object to be molded W1.

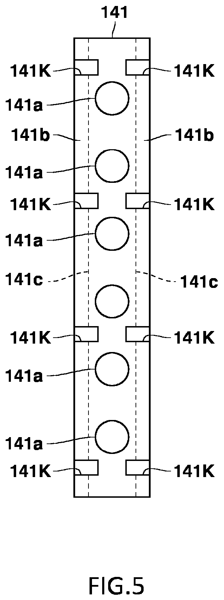

The holding claws 51 of the present embodiment are configured to hook and hold the pot-side end of the object to be molded W1 and the end opposite to the pot-side end. In this configuration, to avoid interference between the holding claws 51 and the pot block 141, the pot block 141 is formed with a recess 141K that avoids interference with the holding claws 51 at positions corresponding to the holding claws 51, as illustrated in FIGS. 4, 5, and the like.

The holding claws 51 is provided on the pressing member 6 so as to be movable in the up-down direction. Specifically, the holding claw 51 is provided on a shaft member 53 provided on the pressing member 6 so as to be movable in the up-down direction, whereby the holding claw is movable in the up-down direction on the pressing member 6.

As illustrated in FIGS. 3, 4, and 7 to 13, the shaft member 53 is provided at each of both ends of the pressing member 6 so as to correspond to the both ends of the object to be molded W1. The shaft member 53 is supported by a support block 55 so as to be rotatable about the central axis of the shaft member 53 to increase or decrease the interval between the holding claws 51. Further, a guide mechanism 54 that guides the movement of the support block 55 (shaft member 53) in the up-down direction with respect to the pressing member 6 is provided between the support block 55 and the pressing member 6. The guide mechanism 54 includes, for example, a rail member provided on the pressing member 6 along the up-down direction, and a slide member provided on the support block 55 to slide the rail member.

As illustrated in FIGS. 3, 4, and 6 to 13, the holding claw drive mechanism 52 includes a holding claw drive unit 521 provided in a housing portion (not illustrated) of the loader 13, and a transmission mechanism 522 that transmits the drive force from the holding claw drive unit 521 to the holding claw 51. Here, the holding claw drive unit 521 is configured using, for example, an air cylinder.

The transmission mechanism 522 transmits the drive force from the holding claw drive unit 521 to the shaft member 53 provided with the holding claw 51 to rotate the shaft member 53. When the shaft member 53 rotates, the interval between the holding claws 51 is increased or reduced.

Specifically, the transmission mechanism 522 includes a link 522a that rotates the shaft member 53 by using the drive force from the holding claw drive unit 521, a first transmission unit 522b and a second transmission unit 522c interposed between the link 522a and the holding claw drive unit 521, and a guide mechanism 522d that contacts the holding claw drive unit 521 and transmits the drive force to the link 522a.

The link 522a couples two shaft members 53 provided on the base member 2, and switches between a holding state where the holding claws 51 hold the object to be molded W1 and a release state where the holding claws 51 have released the holding of the object to be molded W1. Specifically, the link 522a includes a coupling link 522a1 that couples the two shaft members 53, and an action lever 522a2 that is connected to the coupling link 522a1 and on which the drive force from the holding claw drive unit 521 acts.

In the present embodiment, since the pressing member 6 moves up and down with respect to the base member 2, the shaft member 53 (holding claw 51) provided in the pressing member 6 also moves up and down with respect to the base member 2. That is, the action lever 522a2 of the link 522a coupled to the shaft member 53 also moves up and down with respect to the base member 2.

Here, the first transmission unit 522b transmits the drive force from the holding claw drive unit 521 to the holding claw 51 at a position where the action lever 522a2 has lifted with respect to the base member 2 (See FIGS. 4, 12, and 13). Specifically, the first transmission unit 522b includes a contact part such as a contact roller that is moved by the holding claw drive unit 521 and acts on the action lever 522a2 that has lifted. The position where the action lever 522a2 has lifted with respect to the base member 2 is a position where the pressing member 6 is at a second height position R to be described later.

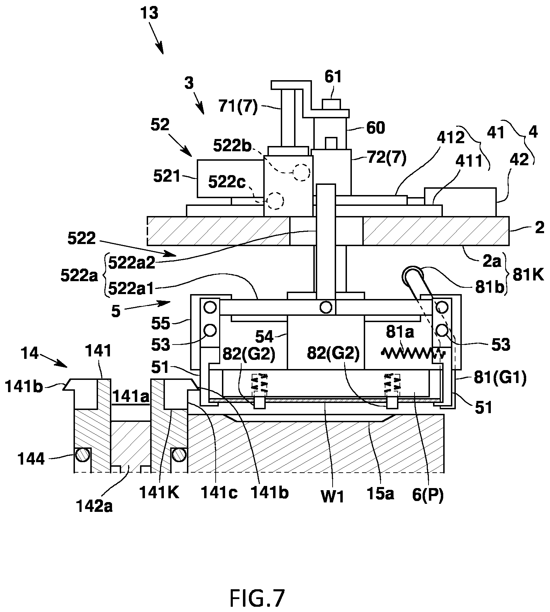

The second transmission unit 522c transmits the drive force from the holding claw drive unit 521 to the holding claw 51 at a position where the action lever 522a2 has lowered with respect to the base member 2 (see FIGS. 7 to 11). Specifically, the second transmission unit 522c includes a contact part such as a contact roller that is moved by the holding claw drive unit 521 and acts on the action lever 522a2 that has lowered. The position where the action lever 522a2 has lowered with respect to the base member 2 is a position where the pressing member 6 is at a first height position P to be described later.

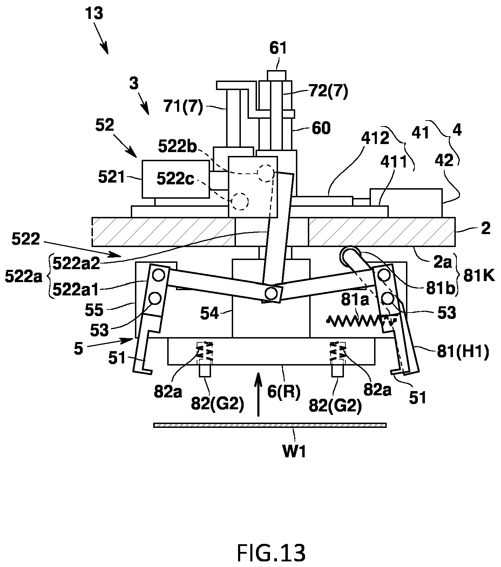

Here, when a drive force is applied to the action lever 522a2 by the first transmission unit 522b at the position (second height position R) where the action lever 522a2 (pressing member 6) has lifted with respect to the base member 2, the interval between the holding claws 51 increases, and the object to be molded W1 can be received (see FIG. 13). That is, the position (second height position R) where the action lever 522a2 (pressing member 6) has lifted with respect to the base member 2 is a receiving position where the holding claws 51 of the substrate holder 3 receive the object to be molded W1.

When a drive force is applied to the action lever 522a2 by the second transmission unit 522c at the position (first height position P) where the action lever 522a2 (pressing member 6) has lowered with respect to the base member 2, the interval between the holding claws 51 increases, and the holding of the object to be molded W1 can be released. That is, the position where the action lever 522a2 (pressing member 6) has lowered with respect to the base member 2 (first height position P) is a transfer height position where the holding claws 51 of the substrate holder 3 release the holding of the object to be molded W1.

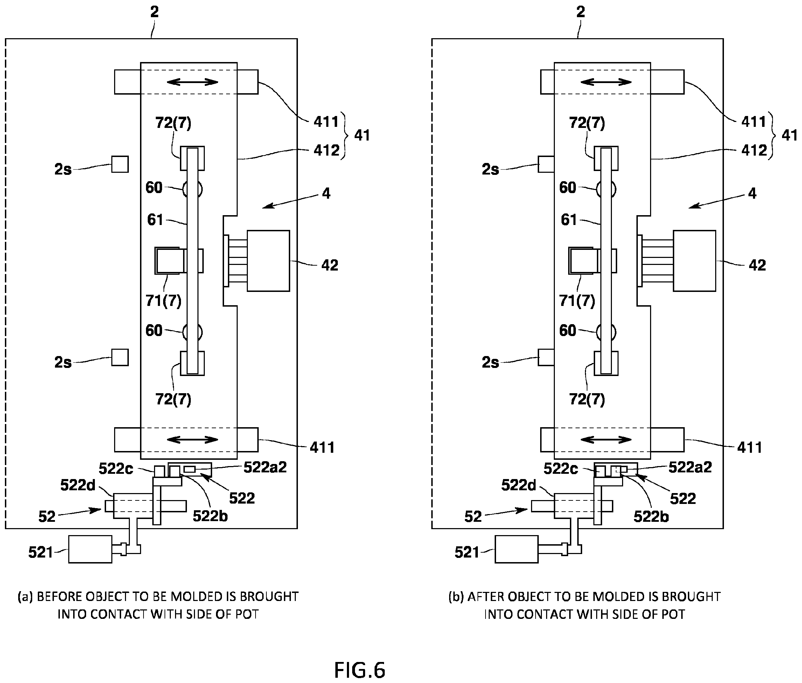

As illustrated in FIGS. 3 and 6, the first transmission unit 522b and the second transmission unit 522c described above are configured such that the movement thereof is guided by the guide mechanism 522d. The guide mechanism 522d includes a guide rail provided on the base member 2 and a slide member slidably provided on the guide rail. The guide rail is provided along a direction in which the first transmission unit 522b and the second transmission unit 522c operate the action lever 522a2.

As illustrated in FIGS. 3, 4, and 7 to 13, the pressing member 6 presses the outer peripheral edge of the object to be molded W1 to prevent warpage of the object to be molded W1. On the lower surface of the pressing member 6, a pressing part (not illustrated) that is in contact with, for example, the outer peripheral edge of the object to be molded W1, is provided, and a recess (not illustrated) that houses the electronic component Wx mounted on the object to be molded W1 is formed. The pressing member 6 is provided to be movable in the up-down direction with respect to the base member 2 by, for example, two coupling shafts 60. The coupling shafts 60 of the present embodiment penetrate the base member 2 and are coupled to each other at an upper portion of the base member 2 with a coupling bar 61.

As illustrated in FIGS. 3, 4, and 6 to 13, the lifting movement mechanism 7 is provided on the base member 2 to adjust the height position of the pressing member 6 with respect to the lower mold 15 or the object to be molded W1 placed on the lower mold 15.

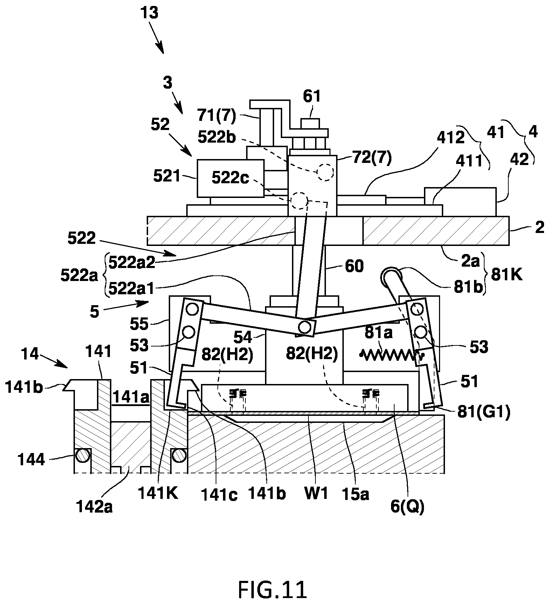

Specifically, the lifting movement mechanism 7 includes a first lifting unit 71 that moves the pressing member 6 up and down between the first height position P (see FIGS. 7 to 10) at which the pressing member 6 approaches the object to be molded W1 and a pressing position Q (see FIG. 11) at which the pressing member 6 presses the object to be molded W1. The lifting movement mechanism 7 also includes a second lifting unit 72 that lifts the pressing member 6 to the second height position R (see FIGS. 4, 12, and 13) located above the first height position P. The first lifting unit 71 and the second lifting unit 72 are configured using, for example, an air cylinder. The first lifting unit 71 and the second lifting unit 72 of the present embodiment adjust the height position of the pressing member 6 by moving the coupling bar 61 up and down.

Here, when the pressing member 6 is at the first height position P, the object to be molded W1 held by the holding claws 51 is at a height position between the upper surface of the lower mold 15 and the overhang 141b. The first height position P of the pressing member 6 is the transfer height position at which the holding claws 51 of the substrate holder 3 release the holding of the object to be molded W1. The second height position R of the pressing member 6 is a receiving position where the holding claws 51 of the substrate holder 3 above the pressing member 6 receive the object to be molded W1.

As illustrated in FIGS. 3, 4, and 6 to 13, the holder moving mechanism 4 horizontally moves the substrate holder 3 holding the object to be molded W1 toward the pot block 141 to bring the object to be molded W1 into contact with the lower side 141c of the overhang 141b of the pot block 141. At this time, the object to be molded W1 held by the substrate holder 3 is separated from the lower mold 15 with a space (floating from the upper surface of the lower mold 15). The object to be molded W1 before being moved toward the pot block 141 by the holder moving mechanism 4 is positioned on the outer side with respect to the overhang 141b.

The holder moving mechanism 4 of the present embodiment moves the pressing member 6 in the horizontal direction to move the object to be molded W1 held by the holding claws 51 in the horizontal direction.

Specifically, the holder moving mechanism 4 includes a guide mechanism 41 for moving the pressing member 6 in the horizontal direction with respect to the base member 2, and a horizontal drive unit 42 for moving the pressing member 6 along the guide mechanism 41.

The guide mechanism 41 includes a rail 411 provided along a first direction toward the pot block 141 in the base member 2, and a slide member 412 that slides on the rail 411. The pressing member 6 is provided on the slide member 412 so as to be slidable in the up-down direction. The horizontal drive unit 42 is configured using, for example, an air cylinder.

The base member 2 of the present embodiment is provided with a movement restriction part 2s that comes into contact with the slide member 412 and restricts further movement toward the pot block 141 (see FIG. 6). The movement restriction part 2s prevents the object to be molded W1 from further moving by hitting the slide member 412 moved by the horizontal drive unit 42 at the timing when the object to be molded W1 comes into contact with the side 141c of the pot block 141 located below the overhang 141b. This prevents an application of an excessive force to the object to be molded W1 in contact with the side 141c.

Further, as illustrated in FIGS. 3, 4, and 7 to 13, the substrate holder 3 of the present embodiment includes a first guide member 81 that guides the object to be molded W1 released from holding to the upper surface of the lower mold 15. The first guide member 81 guides the object to be molded W1 to the upper surface of the lower mold 15 by coming into contact with or close to the end of the object to be molded W1 on the side opposite to the pot-side end.

Specifically, the first guide member 81 is rotatably provided on the shaft member 53 to which the holding claw 51 is coupled. The first guide member 81 is movable between a guide position G1 (see FIGS. 3 and 7 to 11) for guiding the object to be molded W1 to the upper surface of the lower mold 15 and a retraction position H1 (see FIGS. 4, 12, and 13) retracted from the guide position G1. The retraction position H1 is a position rotated outward from the guide position G1, and is a position that does not block the holding claws 51 from receiving the object to be molded W1.

Elastic force is applied to the first guide member 81 of the present embodiment by an elastic member 81a so as to be positioned at the guide position G1, and in a state where the pressing member 6 is at the first height position P and the pressing position Q (see FIGS. 3 and 7to 11), the first guide member 81 is at the guide position G1. On the other hand, when the pressing member 6 has lifted from the first height position P to the second height position R (see FIGS. 4, 12, and 13), a cam part 81b provided on the first guide member 81 comes into contact with a lower surface 2a of the base member 2. Then, along with the movement of the pressing member 6, the first guide member 81 rotates about the shaft member 53 as a rotation center, and moves to the retraction position H1. The cam part 81b and the lower surface 2a of the base member 2 constitute a cam mechanism 81K that moves the first guide member 81 to the retraction position H1.

Further, as illustrated in FIGS. 3, 4, and 7 to 13, the substrate holder 3 of the present embodiment includes a second guide member 82 that serves as a guide when holding the object to be molded W1 by coming into contact with or close to the end surface of the object to be molded W2 excluding the end surface in contact with the side 141c of the pot block 141, and also serves as a guide when dropping the object to be molded W1 into the lower mold 15.

The second guide member 82 is housed in a recess formed on the lower surface of the pressing member 6 via an elastic member 82a. The second guide member 82 protrudes from the lower surface of the pressing member 6 to be movable between a guide position G2 (see FIGS. 3, 4, 7 to 10, 12, and 13) for guiding the object to be molded W1 and a retraction position H2 (see FIG. 11) buried in the lower surface of the pressing member 6 and retracted from the guide position G2. With this configuration, in a state where the pressing member 6 is at the first height position P and the second height position R (see FIGS. 3, 4, 7 to 10, 12, and 13), the second guide member 82 protrudes from the lower surface and becomes the guide position G2 to guide the object to be molded W1. When the pressing member 6 has lowered from the first height position P to the pressing position Q (see FIG. 11), the second guide member 82 comes into contact with the upper surface of the lower mold 15 (when there is a release film, the release film) and is buried to be positioned at the retraction position H2 as the pressing member 6 moves. Because the second guide member 82 is buried to be positioned at the retraction position H2, the pressing member 6 does not interfere with pressing the object to be molded W1.

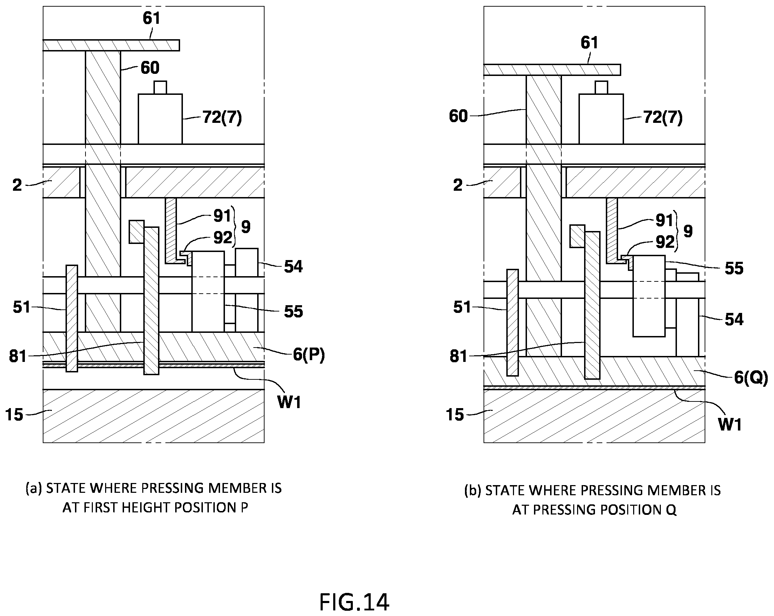

Further, as illustrated in FIGS. 3 and 14, the loader 13 of the present embodiment includes a stopper mechanism 9 that keeps the holding claws 51 and the first guide member 81 at predetermined height positions so that the holding claws 51 and the first guide member 81 do not come into contact with the lower mold 15 when the pressing member 6 lowers.

The stopper mechanism 9 includes a hook 91 provided on the support block 55 that rotatably supports the shaft member 53, and a stopper 92 provided on the base member 2 and on which the hook 91 is caught. With the stopper mechanism 9, as illustrated in FIG. 14, the hook 91 of the support block 55 is caught by the stopper 92 while the pressing member 6 is lowering from the first height position P to the pressing position Q. As a result, the holding claws 51 and the first guide member 81 remain at predetermined height positions without following the lowering of the pressing member 6, and the holding claws 51 and the first guide member 81 do not come into contact with the upper surface (when there is a release film, the release film) of the lower mold 15.

### <Operation of loader 13>

Next, a conveying operation and a positioning operation of the loader 13 will be described with reference to FIGS. 4 and 6 to 14.

The supply module 100A causes the loader 13 to hold the object to be molded W1. Thereafter, the loader 13 is moved to the molding module 100B, and as illustrated in FIG. 4, the loader 13 holding the object to be molded W1 is moved above the lower mold 15. At this time, the pressing member 6 is at the second height position R. Thereafter, the pressing member 6 is lowered from the second height position R to the first height position P by the second lifting unit 72 of the lifting movement mechanism 7 (see FIG. 7). At this time, the coupling bar 61 coupled to the pressing member 6 comes into contact with the first lifting unit 71 of the lifting movement mechanism 7, and the pressing member 6 comes to the first height position P. As a result, the height position of the object to be molded W1 held by the holding claws 51 becomes a height position (transfer height position) between the upper surface of the lower mold 15 and the overhang 141b.

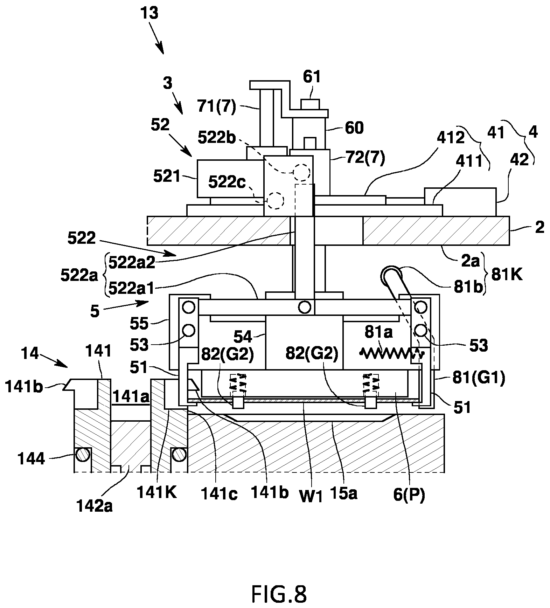

In this state, as illustrated in FIGS. 6 and 8, the holder moving mechanism 4 horizontally moves the pressing member 6 together with the slide member 412 to the pot side. Then, the holder moving mechanism 4 brings the pot-side end of the object to be molded W1 held by the holding claws 51 into contact with the lower side 141c of the overhang 141b of the pot block 141. As a result, the object to be molded W1 is positioned with respect to the pot block 141 in plan view. The first lifting unit 71 of the lifting movement mechanism 7 is provided on the slide member 412, and the first lifting unit 71 of the lifting movement mechanism 7 also moves to the pot side along with the movement of the slide member 412 to the pot side.

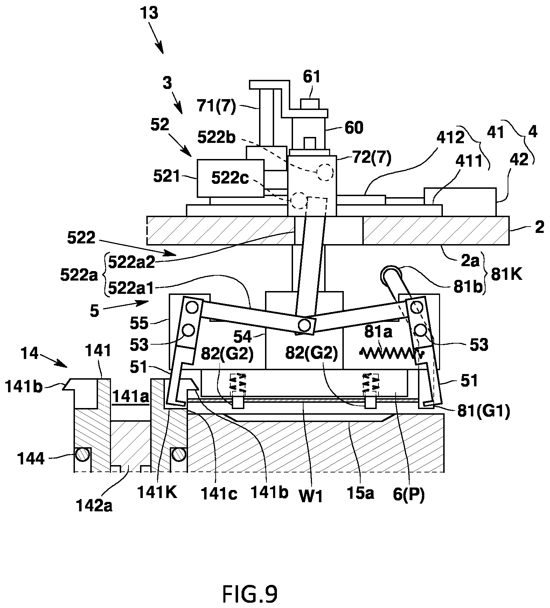

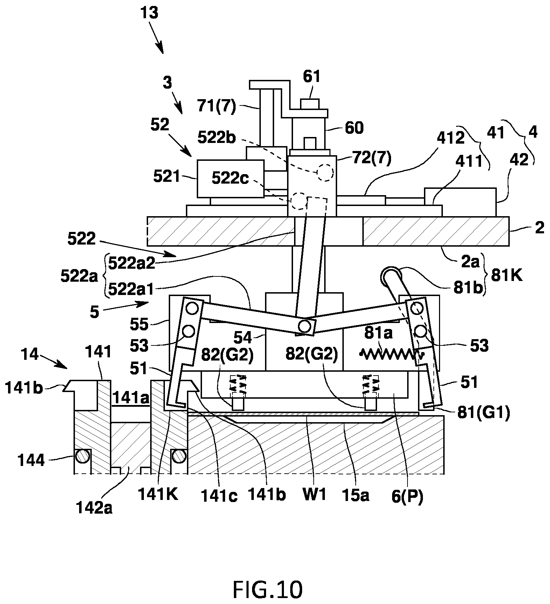

Next, as illustrated in FIG. 9, the holding claw drive mechanism 52 increases the interval between the holding claws 51. At this time, the contact part of the second transmission unit 522c pushes the action lever 522a2 of the link 522a, whereby the interval between the holding claws 51 increases. Since the recess 141K is formed in the pot block 141, the holding claws 51 and the pot block 141 do not interfere with each other. As a result, the holding of the object to be molded W1 is released, and the object to be molded W1 falls and is placed on the lower mold 15 (see FIG. 10). When the object to be molded W1 falls, the object to be molded W1 is guided by the first guide member 81 and the second guide member 82.

Thereafter, as illustrated in FIG. 11, the first lifting unit 71 of the lifting movement mechanism 7 moves the pressing member 6 from the first height position P to the pressing position Q, and the pressing member 6 comes into contact with and presses the outer peripheral edge of the object to be molded W1 that has been positioned. During the lowering of the pressing member 6 from the first height position P to the pressing position Q, the hook 91 is caught by the stopper 92 of the stopper mechanism 9, and the holding claws 51 and the first guide member 81 stay at predetermined height positions without lowering following the lowering of the pressing member 6 (see FIGS. 11 and 14(b)). As a result, the holding claws 51 and the first guide member 81 do not come into contact with the upper surface (release film) of the lower mold 15.

In addition, in a state where the pressing member 6 is in contact with and pressed against the object to be molded W1, the object to be molded W1 is sucked and held by the lower mold 15 with a suction mechanism (not illustrated) provided on the lower mold 15. In the present embodiment, even when the object to be molded W1 is deformed, the object to be molded W1 is pressed by the pressing member 6, and thus the object to be molded W1 can be sucked and held. When a release film is provided to the lower mold 15, a through-hole corresponding to a substrate suction hole of the lower mold 15 is formed in the release film, for example.

After the object to be molded is sucked and held, the first lifting unit 71 of the lifting movement mechanism 7 lifts the pressing member 6 from the pressing position Q to the first height position P. At this time, the hook 91 of the stopper mechanism 9 separates from the stopper 92, and the holding claws 51, the first guide member 81, and the like are placed on the pressing member 6 and follow the lifting of the pressing member 6.

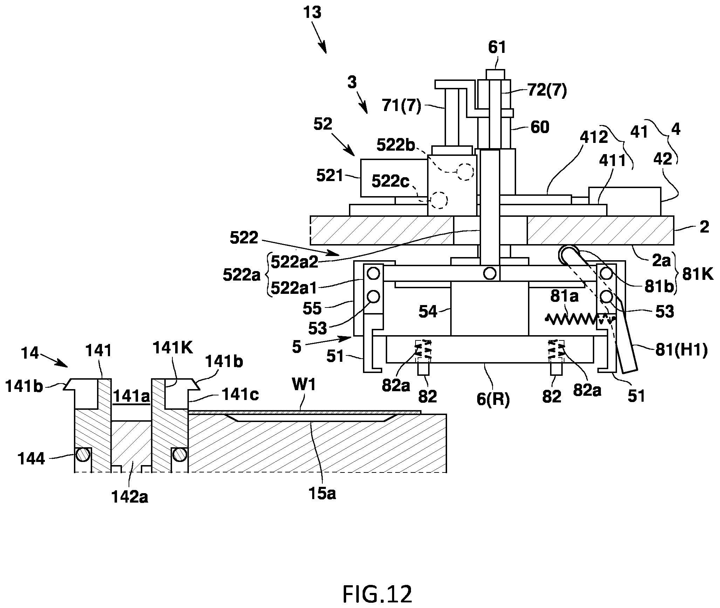

The holder moving mechanism 4 moves the pressing member 6 in a direction away from the pot block 141. Thereafter, the second lifting unit 72 of the lifting movement mechanism 7 lifts the pressing member 6 from the first height position P to the second height position R. At this time, the cam part 81b provided at the upper end of the first guide member 81 comes into contact with the lower surface 2a of the base member 2, and the first guide member 81 rotates about the shaft member 53 as a rotation center and moves to the retraction position H1 (see FIG. 12). Because the first guide member 81 moves to the retraction position H1 in this manner, the first guide member 81 does not become an obstacle when the next object to be molded W1 is held by the holding claws 51 as illustrated in FIG. 13.

After the series of positioning operation (carry-in operation), the supply module 100A causes the resin material J to be housed into the pot 141a of the pot block 141, the resin material J being held by the resin holder (not illustrated) when the loader 13 is caused to hold the object to be molded W1. At this time, the second lifting unit 72 of the lifting movement mechanism 7 lifts the pressing member 6 to the second height position R above the first height position P. This prevents the pressing member 6 from coming into contact with the object to be molded W1 or the like in the operation of supplying the resin material J to the pot block 141 by using the resin holder.

### <Effects of present embodiment>

According to the resin molding apparatus 100 of the present embodiment, the object to be molded W1 is brought into contact with the lower side 141c of the overhang 141b of the pot block 141 in a state where the object to be molded W1 is separated from the lower mold 15, and thereafter, the holding of the object to be molded W1 is released. Thus, the object to be molded W1 can be positioned with respect to the lower mold 15 by the loader 13 and carried in even when a pilot pin or a release film is provided in the lower mold 15 or when an electronic component is fixed to the lower surface of the object to be molded W1, for example. Since the object to be molded W1 positioned by the loader 13 can be sealed in resin, the occurrence of resin burrs can be reduced, and the resin molded product W2 with high quality can be manufactured.

In the present embodiment, since the holder moving mechanism 4 horizontally moves the object to be molded W1, the lower side 141c of the overhang 141b of the pot block 141 and the pot-side end surface of the object to be molded W1 can be reliably brought into contact with each other.

Further, since the substrate holder 3 includes the first guide member 81 and the second guide member 82, when the object to be molded W1 released from holding falls onto the upper surface of the lower mold 15, a state where the pot-side end surface of the object to be molded W1 is in contact with the side 141c of the pot block 141 can be maintained. As a result, the object to be molded W1 can be placed on the lower mold 15 in a positioned state.

In addition, since the substrate holder 3 includes the pressing member 6, the warpage of the object to be molded W1 can be prevented. Here, since the holding claws 51 and the guide members 81 and 82 are provided in the pressing member 6, it is possible to reduce the size as compared with a configuration in which the pressing member 6 and the holding claws or the guide members 81 and 82 are separately provided. In the configuration in which the holding claws 51 and the guide members 81 and 82 are provided on the pressing member 6, when the pressing member 6 is lowered to press the object to be molded W1, the holding claws 51 and the guide members 81 and 82 provided movably in the up-down direction on the pressing member 6 are held at predetermined height positions by the stopper mechanism 9. Thus, the holding claws 51 and the guide members 81 and 82 can be prevented from coming into contact with the lower mold 15 or the release film provided on the lower mold 15.

### <Other modified embodiments>

The present invention is not limited to the above embodiment.

For example, in the above embodiment, the holding claws 51 or the first guide member 81 is provided in the pressing member 6, but the holding claws 51 or the first guide member 81 may be provided in a member (for example, the base member 2) different from the pressing member 6. Here, when the holding claws 51 or the first guide member 81 is provided on a member different from the pressing member 6, the pressing member 6 does not have to move horizontally.

The holding mechanism 5 of the above embodiment is configured to hook and hold the object to be molded by using the holding claws 51, but it may be configured to suck and hold the object to be molded by using a suction pad.

In the above embodiment, the lifting movement mechanism 7 of the pressing member 6 is configured by the first lifting unit 71 and the second lifting unit 72. However, the mechanism may be configured to move between the first height position P, the pressing position Q, and the second height position R by using one lifting unit.

In the above embodiment, the configuration of the first guide member 81 and the configuration of the second guide member 82 are different from each other, but the configuration of the first guide member 81 and the configuration of the second guide member 82 may be the same. For example, the first guide member 81 and the second guide member 82 may be in the configuration of the second guide member 82 of the above embodiment, that is, each of the first and second guide members may be housed in a recess formed on the lower surface of the pressing member 6 via an elastic member and may be configured to be able to take a state of protruding from the lower surface of the pressing member 6 and a state of being buried.

In the above embodiment, a cavity is formed in the lower mold, but the cavity does not have to be formed. Further, a pilot pin for positioning may be provided on the upper surface of the lower mold.

The present invention is not limited to the above embodiments, and it is needless to say that various modifications can be made without departing from the gist of the present invention.

### Industrial Applicability

According to the present invention, an object to be molded can be positioned with respect to a pot block having an overhang.

### Reference Signs List

- 100: resin molding apparatus
- W1: object to be molded before molding
- W2: object to be molded after molding (resin molded product)
- 13: loader (conveying apparatus)
- 141: pot block
- 141b: overhang
- 141c: lower side of overhang
- 141K: recess
- 15: lower mold
- 2: base member
- 3: substrate holder
- 4: holder moving mechanism
- 51: holding claw
- 52: holding claw drive mechanism
- 521: holding claw drive unit
- 522b: first transmission unit
- 522c: second transmission unit
- 6: pressing member
- 7: lifting movement mechanism
- 81: first guide member
- 81a: elastic member
- G1: guide position
- H1: retraction position
- 82: second guide member
- 82a: elastic member
- G2: guide position
- H2: retraction position
- 9: stopper mechanism

## Claims

1. A conveying apparatus that conveys an object to be molded to a lower mold provided with a pot block having an overhang, the conveying apparatus comprising:
a substrate holder that holds the object to be molded; and
a holder moving mechanism that moves the substrate holder,
wherein
the holder moving mechanism moves the substrate holder toward the pot block in a state where the object to be molded is separated from the lower mold to bring the object to be molded into contact with a lower side of the overhang of the pot block, and
the substrate holder releases holding of the object to be molded after the object to be molded is brought into contact with the side by the holder moving mechanism.

2. The conveying apparatus according to claim 1,
wherein the holder moving mechanism horizontally moves the substrate holder toward the pot block to bring the object to be molded into contact with the side in a state where the object to be molded is at a height position between an upper surface of the lower mold and the overhang.

3. The conveying apparatus according to claim 1 or 2,
wherein the substrate holder includes:
a holding claw that holds the object to be molded; and
a holding claw drive mechanism that releases holding by the holding claw.

4. The conveying apparatus according to claim 3, further comprising a base member in which the holding claw is provided to be at least movable up and down,
wherein
the holding claw receives the object to be molded from an outside at a position where the holding claw has lifted with respect to the base member, and releases holding of the object to be molded at a position where the holding claw has lowered with respect to the base member, and
the holding claw drive mechanism includes:
a holding claw drive unit provided in the base member;
a first transmission unit that transmits a drive force from the holding claw drive unit to the holding claw at a position where the holding claw has lifted with respect to the base member; and
a second transmission unit that transmits the drive force from the holding claw drive unit to the holding claw at a position where the holding claw has lowered with respect to the base member.

5. The conveying apparatus according to claim 3 or 4,
wherein the pot block is formed with a recess that avoids interference with the holding claw.

6. The conveying apparatus according to any one of claims 1 to 5,
wherein the substrate holder includes a guide member that guides the object to be molded released from holding to an upper surface of the lower mold.

7. The conveying apparatus according to any one of claims 1 to 6,
wherein the substrate holder includes:
a pressing member that presses the object to be molded placed on the lower mold; and
a lifting movement mechanism that moves the pressing member up and down with respect to the object to be molded.

8. The conveying apparatus according to claim 1 or 2,
wherein the substrate holder includes:
a pressing member that presses the object to be molded placed on the lower mold;
a lifting movement mechanism that moves the pressing member up and down with respect to the object to be molded;
a holding claw that hooks and holds the object to be molded, the holding claw being provided movably in an up-down direction on the pressing member; and
a stopper mechanism that keeps the holding claw at a predetermined height position where the holding claw does not come into contact with the lower mold when the pressing member lowers.

9. The conveying apparatus according to claim 8, wherein
the substrate holder further includes a guide member that guides the object to be molded released from holding to an upper surface of the lower mold, the guide member being provided movably in an up-down direction on the pressing member, and
the stopper mechanism keeps the guide member at a predetermined height position where the guide member does not come into contact with the lower mold when the pressing member lowers.

10. The conveying apparatus according to claim 9,
wherein the guide member is movably provided between a guide position where the guide member guides the object to be molded to the upper surface of the lower mold and a retraction position where the guide member is retracted from the guide position, receives elastic force of an elastic member to be positioned at the guide position, and is configured to be movable to the retraction position with movement of the pressing member.

11. A resin molding apparatus comprising the conveying apparatus according to any one of claims 1 to 10.

12. A resin molded product manufacturing method for performing resin molding on an object to be molded, the resin molded product manufacturing method comprising:
a positioning step of positioning the object to be molded with respect to a pot block by using the conveying apparatus according to any one of claims 1 to 10; and
a molding step of performing resin molding in a state where the object to be molded is positioned.
